(19) Europäisches Patentamt
European Patent Office
Office européen des brevets

(11) **EP 4 489 251 A1**

(12) **EUROPEAN PATENT APPLICATION**
published in accordance with Art. 153(4) EPC

(43) Date of publication:
**08.01.2025 Bulletin 2025/02**

(21) Application number: **22928796.6**

(22) Date of filing: **28.02.2022**

(51) International Patent Classification (IPC):
$H02J\ 7/00^{(2006.01)}$     $G01R\ 31/382^{(2019.01)}$
$G01R\ 31/387^{(2019.01)}$

(52) Cooperative Patent Classification (CPC):
**G01R 31/382; G01R 31/387; H02J 7/00;**
**Y02E 60/10**

(86) International application number:
**PCT/JP2022/008434**

(87) International publication number:
**WO 2023/162274 (31.08.2023 Gazette 2023/35)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Kyocera Corporation**
**Kyoto-shi, Kyoto 612-8501 (JP)**

(72) Inventors:
• **SATO, Masanobu**
**Kyoto-shi, Kyoto 612-8501 (JP)**

• **KUBOTANI, Tsuyoshi**
**Kyoto-shi, Kyoto 612-8501 (JP)**
• **ISHIDA, Yuya**
**Kyoto-shi, Kyoto 612-8501 (JP)**
• **ODA, Yuki**
**Kyoto-shi, Kyoto 612-8501 (JP)**
• **FUKUSHIMA, Takaaki**
**Kyoto-shi, Kyoto 612-8501 (JP)**

(74) Representative: **TBK**
**Bavariaring 4-6**
**80336 München (DE)**

(54) **SOC ESTIMATION DEVICE, PROGRAM, AND SOC ESTIMATION METHOD**

(57) An SOC estimating apparatus (7) includes an OCV calculator (76) and an SOC estimator (77). The OCV calculator (76) is configured to acquire voltage values sampled from a storage battery (3) for a predetermined period, determine based on the sampled voltage values a fitting function including a term with a base of natural logarithm e raised to a power of square root of time t, and calculate an OCV using the determined fitting function when an exception condition is not satisfied. The SOC estimator (77) is configured to estimate an SOC based on the calculated OCV

FIG. 1

## Description

TECHNICAL FIELD

The present disclosure relates to an SOC estimating apparatus, a program, and an SOC estimating method.

BACKGROUND OF INVENTION

Storage batteries are used in various fields, such as storage battery systems for family use and batteries for automobiles and mobile devices. Managing an SOC (state of charge, charge rate) is necessary to use a storage battery. The SOC represents a ratio of an amount of charged electricity to a full charge capacity of the storage battery. Various methods of estimating the SOC have been proposed. For example, in a technique in Patent Literature 1, a resistance ratio between a resistance during charging and a resistance during discharging of a storage element is calculated, and the SOC is estimated based on a relationship between the resistance ratio and the SOC.

CITATION LIST

PATENT LITERATURE

Patent Literature 1: Japanese Unexamined Patent Application Publication No. 2017-034814

SUMMARY

PROBLEM TO BE SOLVED

An SOC is estimated or corrected with a known method based on a correlation between an OCV (open circuit voltage, voltage of an open circuit) and the SOC (an SOC-OCV curve) of a storage battery. In a method in which the SOC-OCV curve is used, a high degree of accuracy of OCV estimation is necessary to achieve a high degree of accuracy of the SOC, which is a final result of estimation.

In consideration of the above circumstances, the present disclosure provides an SOC estimating apparatus, a program, and an SOC estimating method that enable highly accurate estimation of the SOC based on the OCV

SOLUTION TO PROBLEM

In an embodiment of the present disclosure, an SOC estimating apparatus includes an OCV calculator and an SOC estimator.

The OCV calculator is configured to acquire voltage values sampled from a storage battery for a predetermined period, determine based on the sampled voltage values a fitting function including a term with a base of natural logarithm e raised to a power of square root of time t, and calculate an OCV using the determined fitting function when an exception condition is not satisfied.

The SOC estimator is configured to estimate an SOC based on the calculated OCV

In an embodiment of the present disclosure, a program includes instructions to cause a computer to function as an OCV calculator and an SOC estimator.

The OCV calculator is configured to acquire voltage values sampled from a storage battery for a predetermined period, determine based on the sampled voltage values a fitting function including a term with a base of natural logarithm e raised to a power of square root of time t, and calculate an OCV using the determined fitting function when an exception condition is not satisfied.

The SOC estimator is configured to estimate an SOC based on the calculated OCV

In an embodiment of the present disclosure, an SOC estimating method to be performed at an SOC estimating apparatus including a controller includes causing the controller to:

acquire voltage values sampled from a storage battery for a predetermined period;
determine based on the sampled voltage values a fitting function including a term with a base of natural logarithm e raised to a power of square root of time t;
calculate an OCV using the determined fitting function when an exception condition is not satisfied; and
estimate an SOC based on the calculated OCV

ADVANTAGEOUS EFFECT

The present disclosure can provide an SOC estimating apparatus, a program, and an SOC estimating method that enable highly accurate estimation of the SOC based on the OCV

BRIEF DESCRIPTION OF THE DRAWINGS

FIG. 1 is an illustration of a schematic configuration of a storage battery system including an SOC estimating apparatus according to an embodiment of the present disclosure.
FIG. 2 is a flowchart illustrating an SOC estimating method according to an embodiment of the present disclosure.
FIG. 3 illustrates a time dependence of a voltage value of a storage battery.
FIG. 4 illustrates a relationship between values used in a fitting function.

DESCRIPTION OF EMBODIMENTS

An SOC estimating apparatus and an SOC estimating method in an embodiment of the present disclosure will be described hereinafter with reference to the drawings.

(Configuration of Storage Battery System)

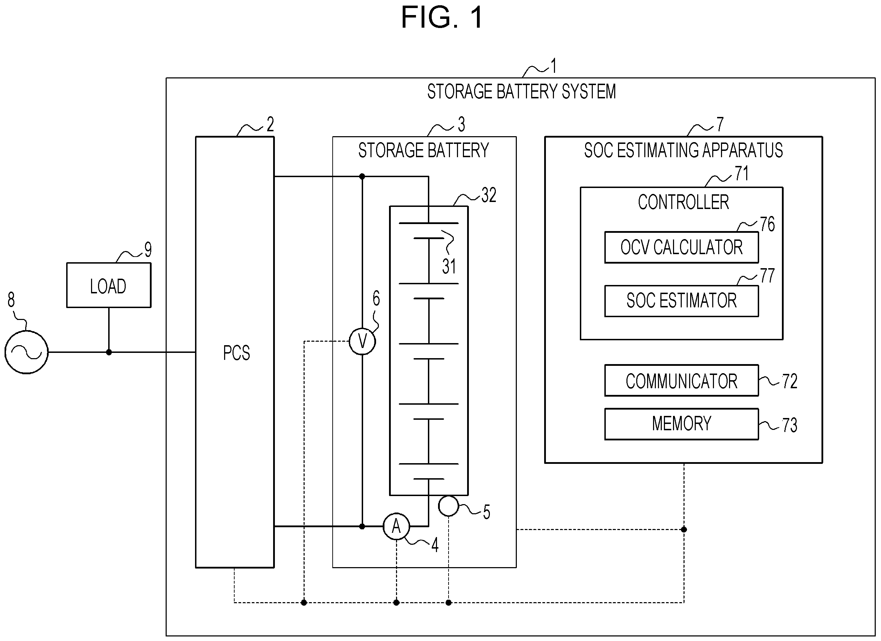

FIG. 1 is an illustration of a schematic configuration of an example of a storage battery system 1 including an SOC estimating apparatus 7 according to an embodiment of the present disclosure. The storage battery system 1 includes a power conditioner 2, a storage battery 3, a current sensor 4, a temperature sensor 5, a voltage sensor 6, and the SOC estimating apparatus 7. The SOC estimating apparatus 7 is configured to estimate an SOC of the storage battery 3, and a charging state of the storage battery 3 is managed based on the estimated SOC in the storage battery system 1. The SOC estimating apparatus 7 may be constructed as part of a managing apparatus for storage battery (BMS: Buttery Management System) configured to manage charging and discharging of the storage battery 3 or may be constructed separately from the managing apparatus for storage battery. The power conditioner 2 is also referred to as a PCS (power conditioning system). In the storage battery system 1, the storage battery 3 is connected to a power system 8, a load 9, and the like located outside the storage battery system 1 with the power conditioner 2 interposed therebetween. Thus, the storage battery system 1 is able to supply electric power stored in the storage battery 3 to the power system 8, the load 9, and the like. The storage battery system 1 is also able to charge the storage battery 3 with electric power supplied from the power system 8 or the like.

As indicated by a dashed line in FIG. 1, the power conditioner 2, the storage battery 3, the current sensor 4, the temperature sensor 5, the voltage sensor 6, and the SOC estimating apparatus 7 are communicatively connected to each other using wireline or wireless communication via a network such as a CAN (controller area network). In an embodiment, as depicted in FIG. 1, description will be given on the assumption that the storage battery system 1 includes one of each of the power conditioner 2, the storage battery 3, the current sensor 4, the temperature sensor 5, the voltage sensor 6, and the SOC estimating apparatus 7, but the number of each unit may be set to any number. In an embodiment, the SOC estimating apparatus 7 is constructed as part of the managing apparatus for storage battery, but if the SOC estimating apparatus 7 is separate from the managing apparatus for storage battery, the storage battery system 1 may further include the managing apparatus for storage battery.

The power conditioner 2 is configured to convert direct-current power discharged from the storage battery 3 to outside into alternating-current power. The power conditioner 2 is also configured to convert alternating-current power supplied to the storage battery 3 from outside into direct-current power.

The storage battery 3 is a rechargeable battery, and examples of the storage battery 3 include a lithium-ion battery. The storage battery 3 includes a storage battery module 32 including one or more cells 31. The storage battery 3 is able to store electricity in the one or more cells 31 included in the storage battery module 32 and discharge electricity from the one or more cells 31. In an embodiment, description will be given on the assumption that the storage battery module 32 includes multiple cells 31 connected in series, but the cells 31 may be connected in parallel. The storage battery 3 may include multiple storage battery modules 32 connected in series or in parallel.

The current sensor 4 is configured to measure a current value of a current flowing through the storage battery 3. The current value of the current flowing through the storage battery 3 includes at least one of a current value of a current flowing into the storage battery 3 or a current value of a current flowing out of the storage battery 3. The current sensor 4 is configured to transmit the measured current value to, for example, the SOC estimating apparatus 7 as the current value of the current flowing through the storage battery 3. In an embodiment, the current sensor 4 is connected in series with one terminal of the storage battery module 32. The current sensor 4 is not necessarily connected to the one terminal of the storage battery module 32 and may be connected to any position that allows the current value of the current flowing through the storage battery 3 to be measured.

The temperature sensor 5 is configured to measure a temperature of the storage battery 3. The temperature sensor 5 is configured to transmit the measured temperature to, for example, the SOC estimating apparatus 7 as the temperature of the storage battery 3. In an embodiment, the temperature sensor 5 is disposed on a surface outside one terminal of the storage battery module 32. The temperature sensor 5 is not necessarily disposed on the surface outside the one terminal of the storage battery module 32 and may be disposed at any position that allows the temperature of the storage battery 3 to be measured.

The voltage sensor 6 is configured to measure a voltage value of the storage battery 3. The voltage sensor 6 is configured to transmit the measured voltage value to, for example, the SOC estimating apparatus 7 as the voltage value of the storage battery 3. Examples of the voltage value of the storage battery 3 include voltage values during charging and during discharging and a value of an open circuit voltage with no current flowing. In an embodiment, the voltage sensor 6 is connected in parallel with both terminals of the storage battery module 32. The voltage sensor 6 is not necessarily connected to both terminals of the storage battery module 32 and may be disposed at any position that allows the voltage value of the storage battery 3 to be measured.

The SOC estimating apparatus 7 is configured to estimate an SOC of the storage battery 3 to manage the storage battery 3. In an embodiment, the SOC estimating apparatus 7 is configured to communicate with the current sensor 4, the voltage sensor 6, and the like and acquire the current value of the current flowing through the storage battery 3 and the voltage value of the storage battery 3. The SOC estimating apparatus 7 may be configured to communicate with the temperature sensor 5 and acquire the temperature of the storage battery 3. In an embodiment, the voltage value of the storage battery 3 is given by, but not limited to, an average voltage of the cells 31.

The SOC estimating apparatus 7 is configured to estimate an OCV of the storage battery 3 and estimate the SOC based on a correlation between the OCV and the SOC (an SOC-OCV curve). In an embodiment, the SOC estimating apparatus 7 is configured to calculate the SOC of the storage battery 3 (referred to as an initial SOC hereinafter) based on the acquired current value of the storage battery 3 by using a current integration method, which is a known method. The SOC estimating apparatus 7 is configured to then correct based on the estimated OCV the initial SOC calculated with the current integration method and output a final SOC of the storage battery 3 (sometimes referred to as a final SOC hereinafter). The SOC estimating apparatus 7 may be configured to output an OCV flag indicating that the SOC to be output has been subjected to correction based on the estimated OCV In the current integration method, the SOC estimating apparatus 7 may be configured to calculate the initial SOC after correcting using a known method the current value of the storage battery 3 for temperature based on an acquired temperature of the storage battery 3. In another example of a configuration, an apparatus other than the SOC estimating apparatus 7 may be configured to calculate the initial SOC, and the SOC estimating apparatus 7 may be configured to acquire the calculated initial SOC. The SOC estimating apparatus 7 may be configured to calculate (estimate) the final SOC by correcting the acquired initial SOC based on the OCV at this time. An initial value of the integrated current and a final value of the integrated current may be calculated instead of the initial SOC and the final SOC, which represent a ratio to a full charge capacity of the storage battery 3.

(Configuration of SOC Estimating Apparatus)

In an embodiment, a schematic configuration of the SOC estimating apparatus 7 will be described with reference to FIG. 1. As illustrated in FIG. 1, the SOC estimating apparatus 7 includes a controller 71, a communicator 72, and a memory 73. The controller 71 includes an OCV calculator 76 and an SOC estimator 77. The controller 71, the communicator 72, and the memory 73 are communicatively connected to each other using wireline or wireless communication. The SOC estimating apparatus 7 may be achieved by a computer.

The controller 71 includes one or more processors. Examples of the one or more processors include a general-purpose processor such as a CPU (central processing unit) and a dedicated processor configured to specialize in specific processing. The controller 71 may include one or more dedicated circuits in addition to the one or more processors. Examples of the one or more dedicated circuits include an FPGA (field-programmable gate array) and an ASIC (application specific integrated circuit). The controller 71 is configured to control the communicator 72 and the memory 73 to implement functionality of the SOC estimating apparatus 7.

The OCV calculator 76 is configured to calculate an OCV based on acquired voltage values of the storage battery 3 and output the calculated OCV to the SOC estimator 77. In an embodiment, the OCV calculator 76 is configured to acquire voltage values sampled from the storage battery 3 for a predetermined period and determine based on the sampled voltage values a fitting function including a term with a base of natural logarithm e raised to the power of square root of time t. The OCV calculator 76 is configured to calculate the OCV using the determined fitting function when an exception condition is not satisfied and designate the voltage value sampled most recently as the OCV when the exception condition is satisfied. Details of the fitting function and the exception condition will be described below.

The SOC estimator 77 is configured to estimate the SOC based on the OCV calculated by the OCV calculator 76. In an embodiment, the SOC estimator 77 is configured to calculate the initial SOC of the storage battery 3 based on the acquired current value of the storage battery 3 and estimate the final SOC by correcting the initial SOC based on the acquired OCV For example, the memory 73 is configured to store the correlation (SOC-OCV curve) to be used for correction by the SOC estimator 77. The SOC estimator 77 is configured to read out the correlation between the OCV and the SOC from the memory 73 upon performing correction.

The SOC estimating apparatus 7 may have a software configuration as follows. The memory 73 is configured to store one or more programs to be used to control operation of the SOC estimating apparatus 7. Once loaded by the processor in the controller 71, the one or more programs stored in the memory 73 cause the controller 71 to function as the OCV calculator 76 and the SOC estimator 77.

The communicator 72 includes one or more communication modules. Examples of the one or more communication modules include a CAN communication module, a wireline LAN (local area network) communication module, and a wireless LAN communication module. In an embodiment, the SOC estimating apparatus 7 is able to communicate via the communicator 72 with the power conditioner 2, the storage battery 3, the current sensor 4, the temperature sensor 5, the voltage sensor 6, and the like included in the storage battery system 1.

Examples of the memory 73 include a semiconductor memory, a magnetic memory, and an optical memory. The memory 73 may be a cache memory or the like of the processor included in the controller 71. The memory 73 may be a volatile storage device or a nonvolatile storage device. The memory 73 is configured to store a system program, an application program, embedded software, information, and the like to implement functionality of the SOC estimating apparatus 7. In an embodiment, the memory 73 is configured to store information including the correlation between the OCV and the SOC and the fitting function.

(Example of Process by SOC Estimating Apparatus)

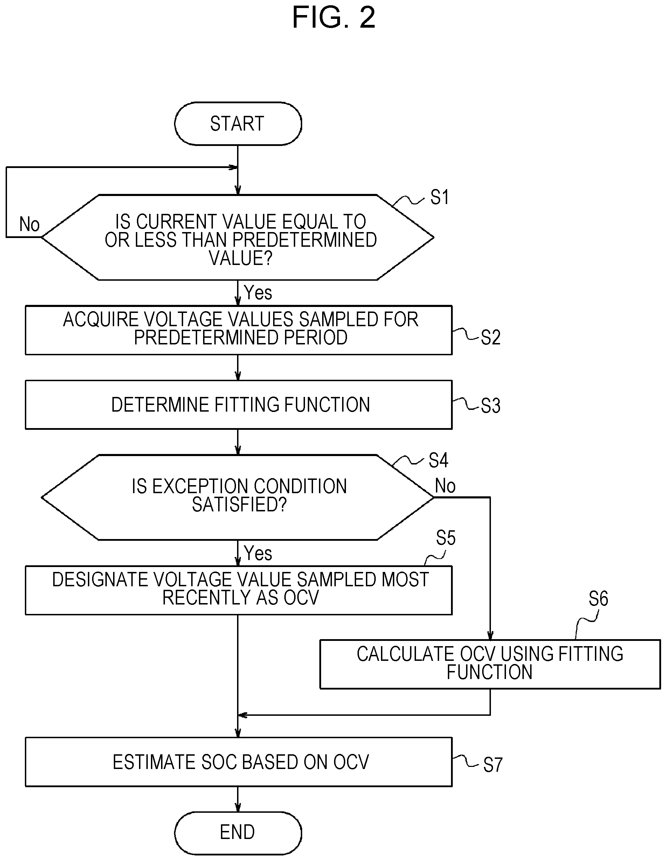

Description will be given with reference to FIG. 2 with regard to an example of a process for estimating the SOC of the storage battery 3 to be performed by the SOC estimating apparatus 7 in an embodiment. In an embodiment, this process corresponds to the SOC estimating method. FIG. 2 illustrates a flowchart of the example of the process by the SOC estimating apparatus 7.

As described above, the SOC estimating apparatus 7 communicates with the current sensor 4, the voltage sensor 6, and the like and acquires the current value of the current flowing through the storage battery 3 and the voltage value of the storage battery 3. The OCV calculator 76 starts to calculate the OCV while the storage battery 3 is neither being charged nor being discharged, that is, while the storage battery 3 is out of operation. In an embodiment, if the current value of the current flowing through the storage battery 3 is equal to or less than a predetermined value (Yes in step S1), the OCV calculator 76 starts to calculate the OCV If the current value is more than the predetermined value (No in step S1), the OCV calculator 76 waits until the current value becomes equal to or less than the predetermined value. The predetermined value is determined in accordance with specifications of the storage battery 3, such as a standby current.

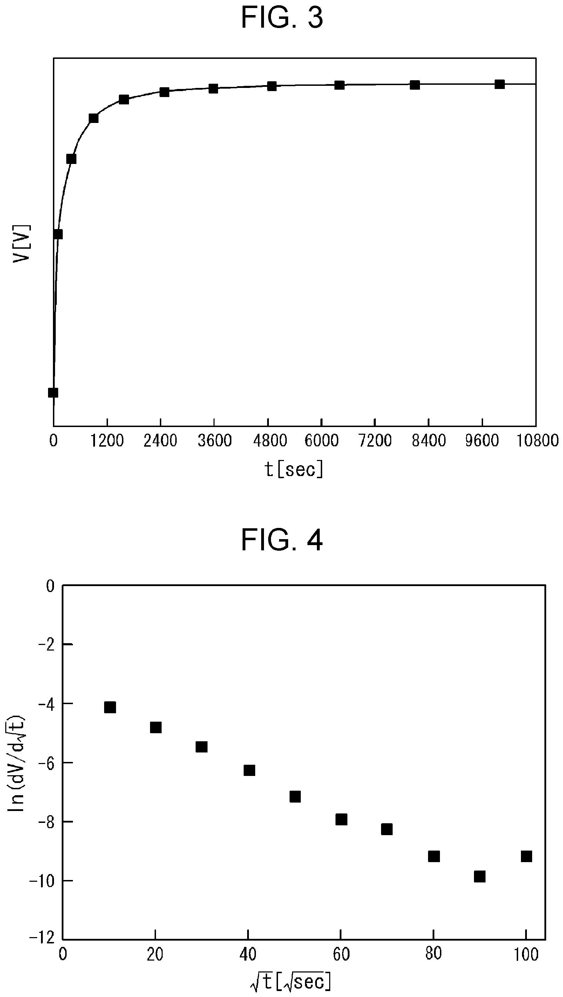

The OCV calculator 76 acquires voltage values sampled for a predetermined period (step S2). The predetermined period may be a waiting period usually used in an OCV measurement. For example, the waiting period is 3 hours. Each of the sampled voltage values is assumed to be represented by V, and V may be associated with t, which is the time that sampling is performed. For example, when sampling is performed at 6 time points, the OCV calculator 76 acquires sampled voltage values $(t_0, V_0)$, $(t_1, V_1)$, $(t_2, V_2)$, $(t_3, V_3)$, $(t_4, V_4)$, and $(t_5, V_5)$. On the assumption that the waiting period is 3 hours (3 h) at this time, the relationship $t_0 < t_1 < t_2 < t_3 < t_4 < t_5 < 3$ h holds. FIG. 3 illustrates a time dependence of the voltage value of the storage battery 3 out of operation. The horizontal axis represents an elapsed time after the storage battery 3 becomes out of operation. The vertical axis represents the voltage value of the storage battery 3.

The OCV calculator 76 uses these sampled voltage values to determine a fitting function to model a voltage variation of the storage battery 3 (step S3). The present inventors conducted a thorough study and found that the voltage variation of the storage battery 3 is accurately approximated by using a fitting function including a term with a base of natural logarithm e raised to the power of square root of time t. In the present disclosure, the fitting function is given by f(t) in Equation (1) as follows:

[Math. 1]

$$f(t) = V_{oc} + ve^{-\sqrt{\omega t}} \quad \dots \text{ Equation (1)}$$

$$V_{oc} = V - \frac{1}{\sqrt{\omega}} \frac{dV}{d\sqrt{t}}$$

$$\sqrt{\omega} = -\frac{d}{d\sqrt{t}} \ln\left(\frac{dV}{d\sqrt{t}}\right),$$

where t represents time, V represents the voltage value, and v represents a coefficient.

In an embodiment, the OCV calculator 76 uses the sampled voltage values to determine the coefficient v in Equation (1). Values related to $\sqrt{\omega}$ in Equation (1) are calculated and plotted in FIG. 4 based on actual values measured for the storage battery 3. The horizontal axis represents square root of time t. The vertical axis represents natural logarithm (ln) of (dV/d√t). The voltage value of the storage battery 3 appears to become a value (estimated value) that is sufficiently close to the OCV as a sufficiently long time elapses. As illustrated in FIG. 4, these values related to $\sqrt{\omega}$ have a relationship linearly decreasing to the estimated value. Thus, the OCV can be estimated as a voltage value V at a time t that $\sqrt{\omega}$ changes to a negative value in f(t) in Equation (1).

In FIG. 4, values of natural logarithm of (dV/d√t) are preferably obtained at regular intervals of √t. Thus, the voltage value of the storage battery 3 is preferably sampled, for example, at $(A \times n)^2$ seconds, where n is an integer equal to or more than 1. For example, the coefficient A is equal to 10.

However, the values related to $\sqrt{\omega}$ do not necessarily display a variation such as illustrated in FIG. 4. In such a case, the OCV calculator 76 may estimate the OCV without using f(t) in Equation (1) on the assumption that the exception condition is satisfied. Specifically, the OCV calculator 76 may determine that the exception condition is satisfied when (dV/d√t) = 0 or $\sqrt{\omega} \le 0$ during a sampling period. For example, the sampling period is a period including $t_0$ to $t_5$ in the above case of sampling at 6 time points.

That is, if the exception condition is satisfied (Yes in step S4), the OCV calculator 76 designates a voltage value sampled most recently as the OCV (step S5). For example, when sampling is performed at 6 time points as described above, the OCV calculator 76 designates "$V_5$" sampled most recently at the time "ts" as the OCV If the exception condition is not satisfied (No in step S4), the OCV calculator 76 calculates the OCV using the fitting function determined as described above (step S6).

Then, the SOC estimator 77 estimates the SOC based on the OCV calculated by the OCV calculator 76 (step S7).

As described above, in an embodiment, the SOC estimating apparatus 7 and the SOC estimating method enable highly accurate estimation of the SOC based on the OCV using the above configuration and process.

As described above, in an embodiment, the sampling period for the voltage values of the storage battery 3 is shorter than the waiting period for a usual OCV measurement. For example, in the case of sampling at 6 time points described above, a period until the time "ts" that "$V_5$" is sampled is shorter than a waiting period known in related art (for example, 3 hours). Thus, in an embodiment, the SOC estimating apparatus 7 and the SOC estimating method enable faster estimation of the SOC than SOC estimating methods known in related art using the OCV

An embodiment of the present disclosure has been described based on the drawings and an example. Note that those skilled in the art easily perform various variations or corrections based on the present disclosure. Accordingly, note that those variations or corrections are within the scope of the present disclosure. For example, each constituent or a function included in each step or the like may be rearranged in a logically compatible manner, and combining multiple constituents or steps or the like into one or dividing a constituent or a step or the like is possible. An embodiment of the present disclosure may also be implemented as a program to be executed by a processor included in an apparatus or implemented as a recording medium storing such a program. It should be appreciated that such a program and such a recording medium are also within the scope of the present disclosure.

For example, in an embodiment described above, the SOC estimating apparatus 7 and the SOC estimating method are configured to estimate the SOC of the storage battery 3 included in the storage battery system 1 by way of non-limiting example, but the SOC estimating apparatus 7 and the SOC estimating method may be applied to other systems and apparatuses including a secondary battery. For example, the SOC estimating apparatus 7 and the SOC estimating method may be used for an electronic apparatus such as a mobile terminal including a lithium-ion battery or the like.

REFERENCE SIGNS

| 1 | storage battery system |
|---|---|
| 2 | power conditioner (PCS) |
| 3 | storage battery |
| 4 | current sensor |
| 5 | temperature sensor |
| 6 | voltage sensor |
| 7 | SOC estimating apparatus |
| 8 | power system |
| 9 | load |
| 31 | cell |
| 32 | storage battery module |
| 71 | controller |
| 72 | communicator |
| 73 | memory |
| 76 | OCV calculator |
| 77 | SOC estimator |

**Claims**

1. An SOC (state of charge) estimating apparatus comprising:

   an OCV (open circuit voltage) calculator configured to acquire voltage values sampled from a storage battery for a predetermined period, determine based on the sampled voltage values a fitting function including a term with a base of natural logarithm e raised to a power of square root of time t, and calculate an OCV using the determined fitting function when an exception condition is not satisfied; and
   an SOC estimator configured to estimate an SOC based on the calculated OCV

2. The SOC estimating apparatus according to claim 1, wherein the OCV calculator is configured to designate one of the voltage values that has been sampled most recently as the OCV when the exception condition is satisfied.

3. The SOC estimating apparatus according to claim 1 or 2,
   wherein the SOC estimator is configured to estimate a final SOC by correcting based on the calculated OCV an initial SOC calculated with a current integration method.

4. The SOC estimating apparatus according to any one of claims 1 to 3,
   wherein the fitting function is given by f(t) in Equation (1) below:
   [Math. 1]

$$f(t) = V_{oc} + ve^{-\sqrt{\omega t}}$$ ... Equation (1)

$$V_{oc} = V - \frac{1}{\sqrt{\omega}}\frac{dV}{d\sqrt{t}}$$

$$\sqrt{\omega} = -\frac{d}{d\sqrt{t}}\ln\left(\frac{dV}{d\sqrt{t}}\right),$$

where V represents the voltage value and v represents a coefficient.

5. The SOC estimating apparatus according to claim 4, wherein the exception condition is satisfied when $(dV/d\sqrt{t}) = 0$ or $\sqrt{\omega} \leq 0$ during a sampling period.

6. A program comprising instructions to cause a computer to function as:

    an OCV calculator configured to acquire voltage values sampled from a storage battery for a predetermined period, determine based on the sampled voltage values a fitting function including a term with a base of natural logarithm e raised to a power of square root of time t, and calculate an OCV using the determined fitting function when an exception condition is not satisfied; and
    an SOC estimator configured to estimate an SOC based on the calculated OCV

7. An SOC estimating method to be performed at an SOC estimating apparatus including a controller, the method comprising causing the controller to:

    acquire voltage values sampled from a storage battery for a predetermined period;
    determine based on the sampled voltage values a fitting function including a term with a base of natural logarithm e raised to a power of square root of time t;
    calculate an OCV using the determined fitting function when an exception condition is not satisfied; and
    estimate an SOC based on the calculated OCV

# FIG. 1

STORAGE BATTERY SYSTEM 1

PCS 2

LOAD 9

8

STORAGE BATTERY 3

32

31

V 6

A 4

5

SOC ESTIMATING APPARATUS 7

CONTROLLER 71

OCV CALCULATOR 76

SOC ESTIMATOR 77

COMMUNICATOR 72

MEMORY 73

EP 4 489 251 A1

# FIG. 2

START

IS CURRENT VALUE EQUAL TO OR LESS THAN PREDETERMINED VALUE? — S1

No

Yes

ACQUIRE VOLTAGE VALUES SAMPLED FOR PREDETERMINED PERIOD — S2

DETERMINE FITTING FUNCTION — S3

IS EXCEPTION CONDITION SATISFIED? — S4

No

Yes

DESIGNATE VOLTAGE VALUE SAMPLED MOST RECENTLY AS OCV — S5

CALCULATE OCV USING FITTING FUNCTION — S6

ESTIMATE SOC BASED ON OCV — S7

END

# FIG. 3

# FIG. 4

## INTERNATIONAL SEARCH REPORT

| International application No. |
|---|
| **PCT/JP2022/008434** |

**A. CLASSIFICATION OF SUBJECT MATTER**

*H02J 7/00*(2006.01)i; *G01R 31/382*(2019.01)i; *G01R 31/387*(2019.01)i
FI: G01R31/387; G01R31/382; H02J7/00 B

According to International Patent Classification (IPC) or to both national classification and IPC

**B. FIELDS SEARCHED**

Minimum documentation searched (classification system followed by classification symbols)

G01R31/36 - 31/396; 19/00 - 19/32; H02J7/00-7/12; 7/34 - 7/36; B60L1/00 - 3/12; 7/00 - 13/00; 15/00 - 58/40

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | US 2016/0231387 A1 (HODGES, Stephen E. et al.) 11 August 2016 (2016-08-11) paragraphs [0022], [0046]-[0047], [0072]-[0076], [0082]-[0083], [0091], fig. 10 | 1-3, 6-7 |
| Y | JP 2021-141722 A (DENSO TEN LTD.) 16 September 2021 (2021-09-16) paragraphs [0004], [0121]-[0126], fig. 7 | 1-3, 6-7 |
| Y | JP 2020-46317 A (TOYOTA INDUSTRIES CORP.) 26 March 2020 (2020-03-26) paragraphs [0048], [0078], [0084]-[0085], fig. 2(a)-(b) | 1-3, 6-7 |
| Y | JP 2017-203748 A (TOYOTA MOTOR CORP.) 16 November 2017 (2017-11-16) paragraphs [0003], [0024] | 1-3, 6-7 |
| A | JP 2018-205309 A (GS YUASA CORP.) 27 December 2018 (2018-12-27) entire text, all drawings | 1-7 |
| A | JP 2013-70534 A (HITACHI CONSTR. MACH. CO., LTD.) 18 April 2013 (2013-04-18) entire text, all drawings | 1-7 |
| A | US 2015/0081237 A1 (YE, Changqing et al.) 19 March 2015 (2015-03-19) entire text, all drawings | 1-7 |

☑ Further documents are listed in the continuation of Box C.   ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **18 April 2022** | **10 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

| INTERNATIONAL SEARCH REPORT | International application No. |
| :---: | :--- |
| | **PCT/JP2022/008434** |

**C.    DOCUMENTS CONSIDERED TO BE RELEVANT**

| Category* | Citation of document, with indication, where appropriate, of the relevant passages | Relevant to claim No. |
| :---: | :--- | :---: |
| A | US 2014/0350875 A1 (MULLIN, Scott Allen et al.) 27 November 2014 (2014-11-27) entire text, all drawings | 1-7 |

Form PCT/ISA/210 (second sheet) (January 2015)

**INTERNATIONAL SEARCH REPORT**
Information on patent family members

International application No.

**PCT/JP2022/008434**

| Patent document cited in search report | | | Publication date (day/month/year) | Patent family member(s) | | | Publication date (day/month/year) |
|---|---|---|---|---|---|---|---|
| US | 2016/0231387 | A1 | 11 August 2016 | WO | 2016/130330 | A1 | |
| | | | | CN | 107209229 | A | |
| JP | 2021-141722 | A | 16 September 2021 | (Family: none) | | | |
| JP | 2020-46317 | A | 26 March 2020 | (Family: none) | | | |
| JP | 2017-203748 | A | 16 November 2017 | (Family: none) | | | |
| JP | 2018-205309 | A | 27 December 2018 | US | 2020/0088807 | A1 | |
| | | | | entire text, all drawings | | | |
| | | | | WO | 2018/221514 | A1 | |
| JP | 2013-70534 | A | 18 April 2013 | (Family: none) | | | |
| US | 2015/0081237 | A1 | 19 March 2015 | CN | 104462632 | A | |
| | | | | entire text, all drawings | | | |
| US | 2014/0350875 | A1 | 27 November 2014 | CN | 104462632 | A | |
| | | | | entire text, all drawings | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017034814 A